Europäisches Patentamt

European Patent Office

Office européen des brevets

(19)

(11) Veröffentlichungsnummer: **0 257 371 B1**

# (12) EUROPÄISCHE PATENTSCHRIFT

(45) Veröffentlichungstag der Patentschrift: 06.03.91

(51) Int. Cl.⁵: **G01R 33/38**

(21) Anmeldenummer: **87111229.8**

(22) Anmeldetag: **04.08.87**

Die Akte enthält technische Angaben, die nach dem Eingang der Anmeldung eingereicht wurden und die nicht in dieser Patentschrift enthalten sind.

(54) **Vorrichtung zum Kompensieren von zeitvarianten Feldstörungen in Magnetfeldern.**

(30) Priorität: **20.08.86 DE 3628161**

(43) Veröffentlichungstag der Anmeldung:
**02.03.88 Patentblatt 88/09**

(45) Bekanntmachung des Hinweises auf die Patenterteilung:
**06.03.91 Patentblatt 91/10**

(84) Benannte Vertragsstaaten:
**CH DE FR GB LI**

(56) Entgegenhaltungen:
**EP-A- 0 116 364      EP-A- 0 138 270
EP-A- 0 160 350      DE-A- 1 937 924
FR-A- 1 578 451      US-A- 3 034 040**

**CRYOGENICS Band 25, Nr.11, 25. November 1985, Seiten 628-636, Guildford, Surrey, GB; Y. MUTO:"Superconducting magnets for very high fields: status in Japan"**

**PATENT ABSTRACTS OF JAPAN Band 8, Nr. 194 (E-264)(1631), 6. September 1984 & JP-A-59-084 406**

**PATENT ABSTRACTS OF JAPAN Band 7,Nr. 15 (P-169)(1160), 21. Januar 1983 & JP-**

**A-57-172 238**

(73) Patentinhaber: **Spectrospin AG
Industriestrasse 26
CH-8117 Zürich-Fällanden(CH)**

(72) Erfinder: **Keller, Anton W.
Odenwaldstrasse 14
W-7512 Rheinstetten(DE)**
Erfinder: **Tschopp, Werner H.
Eggenbergstrasse 11
CH-8127 Forch(CH)**
Erfinder: **Kuster, Anton
Müllerwis 25
CH-8606 Greifensee(CH)**

(74) Vertreter: **Patentanwälte Kohler - Schwindling - Späth
Hohentwielstrasse 41
W-7000 Stuttgart 1(DE)**

## Beschreibung

Die Erfindung betrifft eine Vorrichtung zum Kompensieren von zeitvarianten Feldstörungen in Magnetfeldern von Elektromagneten mit hoher Felthomogenität, insbesondere in Probenräumen von supraleitenden Elektromagneten für Messungen magnetischer Resonanz, bei dem das einen Probenraum des Elektromagneten durchsetzende Magnetfeld mittels mindestens einer Induktionsspule erfaßt, eine in die Induktionsspule induzierte Spannung einer Regelstufe zugeführt und mittels eines Ausgangssignales der Regelstufe ein Kompensationsstrom eingestellt wird, der mindestens eine den Probenraum umschließende Kompensationsspule durchströmt.

Eine derartige Vorrichtung ist aus der DE-A- 33 08 157 bekannt.

Für verschiedene Meßzwecke ist es erforderlich, ein Magnetfelt hoher Feltstärke und hoher Feldhomogenität zu erzeugen. Typische Anwendungsbeispiele sing Messungen der magnetischen Resonanz, d.h. der Kernresonanz oder der Elektronenspinresonanz, homogene Magnetfelder werden aber auch z. B. für die Massenspektrometrie, insbesondere die ICR-Massenspektrometrie, benötigt.

Insbesondere aus der Technik der Kernresonanz ist eine Vielzahl von Vorrichtung bekannt, um ein von einem Elektromagneten, sei es einem Eisenmagneten, einem Luftspulenmagneten, einem supraleitenden Magnetsystem oder einer Kombination derartiger Magnete erzeugtes Magnetfelt hinsichtlich der in der Praxis auftretenden Störungen zu kompensieren.

Neben verschiedenen Techniken zur Kompensation von Homogenitätsstörungen, von denen im vorliegenden Zusammenhang nicht die Rede sein soll, ist es auch bekannt, Störungen zu kompensieren, die sich zeitvariant im Absolutbetrag des Magnetfeldes, typischerweise ausgedrück durch die magnetische Induktion B, manifestieren.

Zur Kompensation sehr niederfrequenter Feldstörungen dieser Art, sogenannter Drifterscheinungen, wird in der Technik der magnetischen Resonanz üblicherweise ein sogenannter "Feldlock" verwendet. Man bedient sich hierzu einer Referenzprobe mit ausgeprägter schmaler Kernresonanzlinie, eines sogenannten "Standards", wobei das gyromagnetische Verhältnis dieser Resonanzlinie, d.h. das Verhältnis der Resonanzfrequenz zur magnetischer Feldstärke genau bekannt ist. Die Kernresonanz dieser Referenzlinie wird ständig angeregt und bei beispielsweiser fest eingestellter Meßfrequenz kann dann erkannt werden, ob infolge von Drifterscheinungen des magnetischen Feldes eine Korrektur erforderlich ist.

Zur Kompensation etwas höher frequenter Störungen der magnetischen Feldstärke ist es von Eisenmagneten her bekannt, eine sogenannte "Fluxstabilisation" vorzunehmen, wie sie beispielsweise in der DE-Z Z. Instr. 67, Seite 293 bis 300 (1959) beschrieben ist. Bei dieser bekannten Anordnung werden konzentrisch zu Polschuhen eines Eisenmagneten Induktionsspulen, sogenannte "Pickup-Spulen" verwendet, mit denen niederfrequente Schwankungen der magnetischen Feldstärke erfaßt werden können, weil derartige Feldschwankungen eine Induktionsspannung in diese Spulen induzieren. Die induzierte Spannung wird einem Gleichspannungsverstärker zugeführt, der seinerseits einen Strom erzeugt, der einer Feldspule des Elektromagneten zugeführt wird. Auf diese Weise ist es möglich, Feldstörungen auszugleichen, die im Bereich von etwa 0,1 bis 1 Hz liegen.

Aus der bereits eingangs genannten DE-A- 33 08 157 ist eine Vorrichtung bekannt, die bei einem supraleitenden Magnetsystem mit mechanisch unmittelbar angebautem Refrigerator eingesetzt wird. Ein supraleitendes Magnetsystem besteht aus einer Solenoidspule, die aus supraleitendem Draht gewickelt und im Inneren eines Cryostaten angeordnet ist, in dem sie sich in einem Bad aus flüssigem Helium befindet. Um das innerste Gefäß mit flüssigem Helium herum befinden sich in der Regel weitere Kälteschilde und Gefäße mit flüssigem Stickstoff, um die zum Betreiben der supraleitenden Spule erforderlichen extrem niedrigen Temperaturen bei möglichst geringen Verlusten aufrechterhalten zu können. Bei dem bekannten supraleitenden Magnetsystem wird nun ein mechanisch unmittelbar angebauter Refrigerator, d.h. ein motorisch betriebenes Kühlgerät verwendet, von dem zwei konzentrische Kühlarme bis in das Innere des Cryostaten hereinreichen und dort vorhandene Kühlschilde bzw. mit flüssigem Stickstoff gefüllte Behälter auf niedriger Temperatur halten.

Bei der bekannten Vorrichtung sind nun Maßnahmen getroffen worden, um diejenigen Störungen auszugleichen, die durch den mechanischen Antrieb des Refrigerators hervorgerufen werden. Da sich im mechanischen Antrieb metallische Teile bewegen, deren Suszeptibilität nicht vernachlässigbar ist, werden hierdurch magnetische Störsignale im Probenraum erzeugt, der sich im Innersten des Cryostaten befindet, die zwar von sehr geringer Amplitude sind, bei hochauflösenden Messungen der magnetischen Resonanz jedoch gleichwohl stören können.

Die bekannte Vorrichtung schlägt hierzu vor, Induktionsspulen entweder unmittelbar am Refrigerator oder aber auch im Bereich des Probenraumes, d.h. im Inneren des Cryostaten vorzusehen, die vom Refrigerator erzeugten Störsignale dort über die in die Spulen induzierten Spannungen zu erfassen und daraus einen Kompensationsstrom für eine Kompensationsspule abzuleiten.

Für den geschilderten Anwendungsfall der Kompensation von Störungen, die von einem in unmittelbarer Nähe der supraleitenden Magnetspule angeordneten mechanischen Aggregat erzeugt werden, ist die geschilderte Vorrichtung ausreichend, weil die geschilderten Störungen während des Betriebes des Refrigerators nach Art und Auswirkung einigermaßen vorhersehbar ist, sodaß mit vergleichsweise einfachen Mitteln die gewünschte Kompensation erreicht werden kann.

Es hat sich jedoch gezeigt, daß mit immer weiter zunehmender Meßgenauigkeit von Magnetsystem, wie sie insbesondere in der hochauflösenden Kernresonanzspektroskopie eingesetzt werden, auch die Empfindlichkeit gegenüber externen Störungen ansteigt und zwar insbesondere bei supraleitenden Magnetsystem, die ohne einen Eisenkern oder -mantel solchen Störungen verhältnismäßig offen ausgesetzt sind, die von außen in unkontrollierter Weise auf das Magnetsystem eingestrahlt werden. Als besonders störend haben sich insbesondere schwere bewegte magnetische Teile erwiesen, wie beispielsweise Aufzüge, Straßenbahnen und dgl. . So hat man beispielsweise gefunden, daß in einem Kernresonanzspektrometer mit supraleitendem Magnetsystem, das in einem üblichen Forschungsinstitut aufgestellt ist, sich Störfelder noch bemerkbar machen, die von einem Lastenaufzug erzeugt werden, der sich 50 m oder mehr entfernt von dem Spektrometerraum befindet, ebenso wie Störungen, die von Straßenbahnen erzeugt werden, die in noch größerer Entfernung von dem Spektrometer auf der Straße verkehren.

Zur Kompensation derartiger Störungen, deren Auftreten weder nach Zeit, noch nach Amplitude, Richtung oder Phase vorhersehbar ist, reichen einfache Vorrichtungen, wie sie in der DE-A- 33 08 157 beschrieben sind schon alleine deswegen nicht aus, weil eine Induktionsspule, die im Probenraum oder um den Probenraum herum angeordnet ist, nur den integralen Fluß des Störfeldes erfassen und in Abhängigkeit davon einen Strom in eine Kompensationsspule einspeisen kann, ohne daß genau bekannte ist, wie nun eigentlich die magnetische Feldstörung am Ort der Probe im Probenraum geartet ist noch welchen Einfluß die Kompensationsspule exakt im Probenraum ausübt. So ist durchaus realistisch, daß mit einer Vorrichtung der eingangs genannten Art zwar makroskopisch die Störung kompensiert zu sein scheint, mikroskopisch zeigt sich jedoch, daß am Ort der Probe selbst noch Feldstörungen verbleiben und nur integral der von der Induktionsspule bzw. der von der Kompensationsspule ausgefüllte Raum kompensiert ist. Das noch am Probenort verbleibende Störfeld wird i.a. einen frequenzabhängigen Amplituden- und Phasengang aufweisen. Ein weiteres Beispiel von Kompensationsvorrichtung ist aus EP-A- 138270 bekannt.

Der Erfindung liegt demgegenüber die Aufgabe zugrunde, eine Vorrichtung der eingangs genannten Art dahingehend weiterzubilden, daß eine Kompensation von zeitvarianten Feldstörungen mit wesentlich erhöhter Präzision möglich ist, gleichzeitig jedoch den realen Gegebenheiten, wie sie durch die Anwesenheit von Meßgerätschaften, insbesondere der Magnetspule selbst, gegeben sind, Rechnung getragen wird.

Diese Aufgabe wird nach der Erfindung zum einen dadurch gelöst, daß mindestens eine Induktionsspule und mindestens zwei Kompensationsspulen vorgesehen sind, und daß in der Regelstufe ein Stromteiler zum Aufteilen des Kompensationsstromes in die beiden Kompensationsspulen vorgesehen ist.

Im Fall vollständiger Flußkompensation ist die Spannung über der Induktionsspule Null d. h. es tritt keine integrale Flußänderung durch die Induktionsspule auf. Im Gegensatz zum Stand der Technik wird dies aber dadurch erreicht, daß Kompensationsströme durch mindestens zwei Kompensationsspulen fließen, deren Verhältnis noch einstellbar ist. Durch Variation dieses zusätzlichen Parameters wird nun erreicht, daß im abgeglichenen Zustand nicht nur die integrale Flußänderung sondern auch die Magnetfeldänderung am Probenort verschwindet.

Die der Erfindung zugrunde liegende Aufgabe wird nach der Erfindung weiter dadurch gelöst, daß mindestens eine Kompensationsspule und mindestens zwei Induktionsspulen vorgesehen sind und daß in der Regelstufe ein Spannungsaddierer vorgesehen ist, dem die induzierten Spannungen der mindestens zwei Induktionsspulen zuführbar sind und unterschiedlich gewichtet werden.

Auch durch diese Maßnahme entsteht ein weiterer freier Parameter, der so eingestellt wird, daß neben der integralen Flußkompensation auch die Änderung des Magnetfeldes am Probenort exakt kompensiert wird.

Prinzipiell wäre es auch denkbar, mit insgesamt nur zwei Spulen geeigneter Abmessungen auszukommen und deren Positionen mechanisoh zu optimieren, d. h. allerdings vollständig immer nur für eine Frequenz des Störsignals. Die in der Erfindung vorgeschlagene Lösung mit insgesamt mindestens drei Spulen hat den Vorteil, daß die Optimierung nicht mehr mechanisch erfolgen muß und daher wesentlich einfacher und variabler wird. Gleichzeitig eröffnet sich die Möglichkeit, Störungen in einem weiten Frequenzbereich zu eliminieren, in dem man die Aufteilung der Ströme bzw. Spannungen frequenzabhängig gestaltet, z. B. durh Einbau mindestens eines Abschwächers oder Verstärkers mit einstellbarem Frequenzgang, d. h. einstellbarer Amplitude und Phase.

Die der Erfindung zugrunde liegende Aufgabe wird deswegen vollkommen gelöst, weil sich die erfindungsgemäße Vorrichtung in einem wesentlichen Punkt von den vorbekannten Vorrichtungen unterscheidet.

Nach der Erfindung werden mindestens drei Spulen verwendet und zwar jeweils mindestens eine Induktionsspule und zwei unterschiedlich gewichtete Kompensationsspulen oder zwei unterschiedlich gewichtete Induktionsspulen und eine Kompensationsspule.

Die Erfindung mit den oben genannten beiden Varianten hat damit den erheblichen Vorteil, daß von außen eindringende Feldstörungen in einer Weise kompensiert werden können, wie dies so gut bislang auch bei hohem Aufwand nicht möglich war. Praktische Versuche haben gezeigt, daß bei Feldstörungen dieser Art, wie sie typischerweise im Frequenzbereich zwischen 0,05 und 5 Hz mit einer Stärke von einigen 10 mG $(1G = 10^{-4}T)$ auftreten, eine Störunterdrückung um Zehnerpotenzen möglich ist. Gerade in dem genannten Frequenzbereich ist dies von erheblichem 'Vorteil, weil sich gezeigt hat, daß supraleitende Magnetsystem im Frequenzbereich von etwa 1 Hz mitunter eigene Resonanzen aufweisen, die zu erheblichen Fehlererhöhungen führen können, so daß eine Fehlerkompensation gerade in diesem Frequenzbereich besonders wichtig und effektiv ist.

Insgesamt hat die Erfindung damit zum Ergebnis, daß zeitvariante Feldstörungen beispielsweise bei Messungen der magnetischen Kernresonanz nahezu über den gesamten Frequenzbereich kompensiert werden können. Während nämlich extrem niederfrequente Feldstörungen, insbesondere Drifterscheinungen in ausreichendem Umfang durch den eingangs geschilderten Feldlock ausgeglichen werden können, ist die erfindungsgemäße Vorrichtung im genannten Frequenzbereich bis hin zu einigen Hz wirksam. Höherfrequente Störungen können allerdings im allgemeinen unkompensiert bleiben, weil sie durch den Magneten abgeschirmt werden bzw. für übliche Kernresonanzmessungen nicht stören.

Bei einer bevorzugten Ausgestaltung der Erfindung sind die Induktionsspulen und die Kompensationsspulen zueinander koaxial angeordnet.

Diese Maßnahme hat den Vorteil, daß die Dimensionierung, Positionierung und Erregund der Spulen leichter berechenbar und handhabbar ist.

Bei einer bevorzugten Variante dieses Ausführungsbeispiels sind die Induktionsspulen und die Kompensationsspulen nicht nur zueinander sondern auch zu Feldspulen des Elektromagneten koaxial angeordnet.

Diese Maßnahme hat den Vorteil, daß durch die erfindungsgemäße Vorrichtung im wesentlichen die axiale Komponente in Richtung der Hauptachse des Magnetsystems kompensiert wird, die für externe Störungen besonders empfindlich ist.

Bei weiteren Ausführungsbeispielen der Erfindung kann mindestens eine Induktionsspule innerhalb oder außerhalb einer Feldspule des Elektromagneten angeordnet sein, ebenso wie mindestens eine Kompensationsspule außerhalb oder auch innerhalb der Feldspule vorgesehen sein kann.

Diese Maßnahme hat den Vorteil, daß auf diese Weise den jeweils vorherrschenden Randbedingungen der Meßapparatur Rechnung getragen werden kann.

Bei einem besonders bevorzugten Ausführungsbeispiel der Erfindung mit außerhalb der Feldspule angeordneter Kompensationsspule ist die Kompensationsspule axial von der Feldspule des Elektromagneten beabstandet und weist einen Durchmesser auf, der wesentlich größer als vorzugsweise mindestens doppelt so groß wie der Durchmesser der Feldspule ist.

Insbesondere ist bei diesem Ausführungsbeispiel der Elektromagnet ein auf einem Gestell oberhalb eines Bodens angeordneter supraleitender Magnet mit senkrechter Achse und die Kompensationsspule ist auf dem Boden unterhalb des Gestells angeordnet.

Diese Maßnahme hat den wesentlichen Vorteil, daß vor allem Fernstörungen kompensiert werden können, wie sie in der bereits weiter oben erläuterten Weise von schweren bewegten magnetischen Teilen in großem Abstand vom Magnetsystem erzeugt werden.

Die Anordnung der Kompensationsspule mit sehr großem Durchmesser außerhalb des Magnetsystems hat nämlich den Vorteil, daß das Kompensationsfeld zumindest näherungsweise als Fernfeld wirkt und daher vom Charakter her die auftretende Störung mit einer dazu gleichartigen Größe kompensiert wird. Dies gilt insbesondere dann, wenn unmittelbar an die Kompensationsspule benachbart eine koaxiale Induktionsspule vorgesehen ist, die die Fernstörung auch als solche erfaßt, wobei dann die dritte erforderliche Spule am oder im Probenraum als kleinere Induktions- oder Kompensationsspule vorgesehen sein kann.

Bei einer bevorzugten Ausgestaltung der Erfindung ist der Elektromagnet ein supraleitender Magnet eines Kernresonanzspektrometers, das einen Regelkreis aufweist, in dem die spektrale Lage einer vorbestimmten Linie einer Referenzprobe überwacht und in abhängigkeit von einer Verschiebung der Linie ein Kompensationsfeld mittels einer Spule erzeugt wird und die Spule gleichzeitig als Kompensationsspule dient.

Diese Maßnahme hat den Vorteil, daß der bereits weiter oben erläuterte Feldlock insoweit mit ausgenutzt wird, als die Spule des Feldlocks gleichzeitig als Kompensationsspule im Sinne der Erfindung benutzt wird. Dies hat den Vorteil, daß kein zusätzlicher Platzbedarf in der Nähe des Probenraumes besteht.

Bei einer bevorzugten Ausgestaltung der Erfindung ist das Verhältnis der mindestens zwei Kompensationsströme oder der mindestens zwei gewichteten Induktionsspannungen frequenzabhängig. Diese Maßnahme hat den Vorteil, daß Störungen nicht nur für eine Frequenz sondern in einem breiten Frequenzband exakt kompensiert werden können.

Weitere Vorteile ergeben sich aus der Beschreibung und den beigefügten Zeichnungen.

Es versteht sich, daß die vorstehend genannten und die nachfolgend noch erläuterten Merkmale nicht nur in der jeweils angegebenen Kombination sondern auch in anderen Kombinationen oder in Alleinstellung verwendet werden können, ohne den Rahmen der vorliegenden Erfindung zu verlassen.

Dies gilt insbesondere für zahlreiche mögliche Anwendungen der erfindungsgemäßen Vorrichtung bei einer Vielzahl von Meßgeräten, bei denen eine Magnetfeld benötigt wird, wie NMR-Spektroskopie und -Tomographie, Massenspektrometer etc., ebenso wie für die nahezu unbegrenzte Variationsbreite bei der Kombination verschiedener Induktions- und Kompensationsspulen innerhalb und außerhalb des Magnetsystems, in dessen Nähe oder in axialem oder radialem Abstand dazu.

Ausführungsbeispiele der Erfindung sind in der Zeichnung dargestellt und werden in der nachfolgenden Beschreibung näher erläutert. Es zeigen:

Fig. 1    ein Prinzipschaltbild eines Flußstabilisators eines Eisenmagneten nach dem Stand dem Technik;

Fig. 2    eine Prinzipdarstellung eines Flußstabilisators in einem supraleitenden Magnetsystem, ebenfalls nach dem Stand der Technik;

Fig. 3    eine Darstellung ähnlich Fig. 2, jedoch in erfindungsgemäßer Abwandlung;

Fig. 4    einen stromlaufplan zur Erläuterung einer Varian te einer Beschaltung des Systems gemäß Fig. 3;

Fig. 5    eine erfindungsgemäße Alternative des Stromlaufplans gemäß Fig. 4;

Fig. 6    eine Darstellung eines ersten praktischen Ausführungsbeispiels eines supraleitenden Magnetsystems nach der Erfindung;

Fig. 7    eine Variante des in Fig. 6 dargestellten Systems;

Fig. 8a,   Kernresonanzlinien, die in Anwesenheit externer
8b, 9a,    zeitvarianter Feldstörungen unterschiedlicher 9b,
10a,       Frequenz nach dem Stand der Technik bzw. mit 10b,
11a,       einer erfindungsgemäßen Vorrichtung gemäß 11b Fig. 7 aufgenommen wurden.

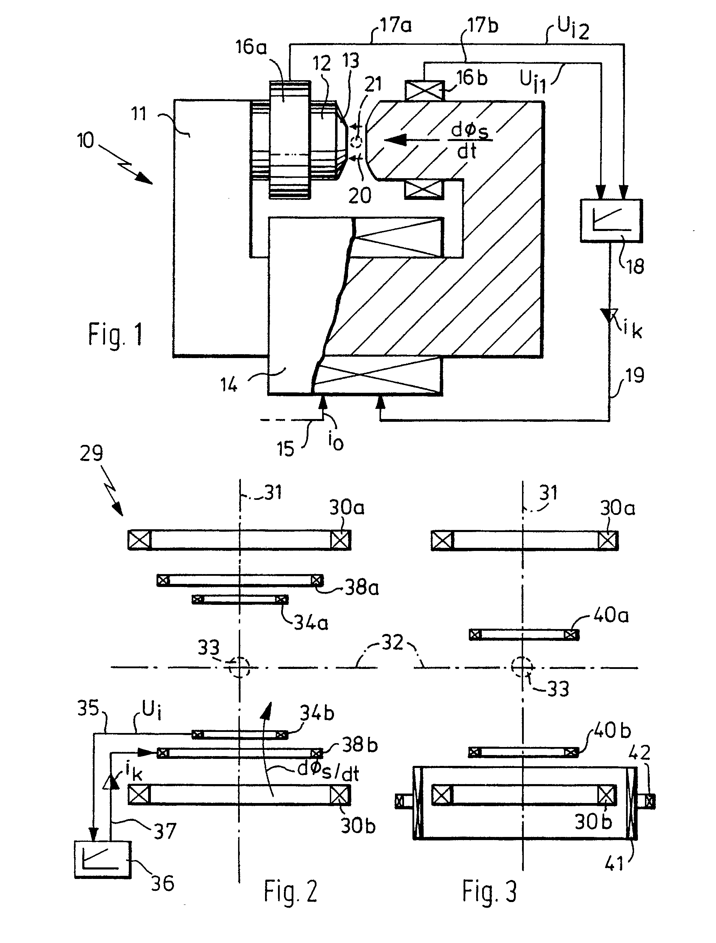

In Fig. 1 ist 10 ein üblicher Elektro-Eisenmagnet mit einem Joch 11, an dem Polkerne 12 angeordnet sind, die wiederum an ihren freien Enden Polschuhe 13 tragen. Ein Erregerwicklung 14 ist um das Joch 11 gewickelt und mit einer Versorgungsleitung 15 versehen, über die ein Erregerstrom $i_0$ in die Erregerwicklung 14 eingespeist wird.

Zusätzlich sind auf die Polkerne 12 Induktionsspulen 16a, 16b gewickelt, die mit Leitungen 17a bzw. 17b an einen Regelverstärker 18 angeschlossen sind. Der Regelverstärker 18 steht über eine Leitung 19 mit der Erregerwicklung 14 oder einer weiteren Feldspule des Elektro-Eisenmagneten 10 in Verbindung. Zwischen den Polschuhen 13 erstreckt sich ein Meßluftspalt 20, in dem ein Probenraum 21 definiert ist.

Wenn in dem Elektro-Eisenmagnet 10 aus irgend welchen Gründen eine zeitvariante Feldstörung in Gestalt einer Flußänderung $d\phi_{s/dt}$ auftritt, so werden infolge der Flußänderung in die Induktionsspulen 16a, 16b Spannungen $U_{i1}$, $U_{i2}$ induziert, die im Regelverstärker 18 in einem Kompensationsstrom $i_k$ umgewandelt werden. Dieser Kompensationsstrom $i_k$ wird in der beschriebenen Weise dazu verwendet, um die zeitvariante Feldstörung $d\phi_{s/dt}$ auszugleichen.

Fig. 2 zeigt eine entsprechende Anordnung für einen Elektro-Luftspulenmagnet 29, der entweder als resistiver Magnet oder als supraleitender Magnet ausgeführt sein kann. Die bei dem Magneten 29 in Fig. 2 verwendeten Spulen sind als Helmholtz-Spulen ausgeführt, sie können jodoch selbstverständlich auch als Solenoidspulen oder als Kombinationen dieser beiden Spulentypen ausgeführt sein. Ein Luftspulenpaar 30a, 30b erzeugt das konstante Hauptfeld im wesentlichen in Richtung einer Längsachse 31, zu der eine Querachse 32 senkrecht angeordnet ist und in deren Schnittpunkt sich ein Probenraum 33 befindet. Ein Induktionsspulenpaar 34a, 34b ist über eine Leitung 35 mit einem Regelverstärker 36 verbunden, der seinerseits über eine Leitung 37 mit einem Kompensationsspulenpaar 38a, 38b verbunden ist.

Die Wirkungsweise der bekannten Anordnung gemäß Fig. 2 entspricht derjenigen von Fig. 1. Eine externe zeitvariante Feldstörung $d\phi_{s/dt}$ durchsetzt die Luftspulen 30a, 30b ebenso wie die Induktionsspulen 34a, 34b, sodaß in die letztgenannten eine Induktionsspannung $U_i$ induziert wird. Der Regelverstärker 36 bildet hieraus einen Kompensationsstrom $i_k$ und speist diesen in die Kompensationsspulen 38a, 38b ein.

Man kann aus Fig. 2 jedoch deutlich erkennen, daß bei der eher zufällig gewählten Konfiguration der Spulen 34/38 jeweils nur integrale Zustände erfaßt bzw. kompensiert werden können. So sind durchaus unsymmetrische oder auch symmetrische Feldzustände innerhalb der von den Spulenpaaren 34/38 umschlossenen Volumina denkbar, wie zwar makroskopisch eine vollkommene Feldstörungskompensation vortäuschen, bei denen jedoch exakt im Probenraum 33 noch Restfehler vorhanden sind.

Nach dem Stand der Technik ist die Positionierung, Dimensionierung und Erregung der Induktions- und Kompensationsspulen 34/38 gemäß Fig. 2 eher zufällig oder nach praktischen Gesichtspunkten bestimmt. Eine denkbare Verbesserung ist es, diese eher zufällige Anordnung dadurch zu verlassen, daß die Induktions- und Kompensationsspulen rechnerisch exakt dimensioniert, positioniert und erregt werden. Dies führt jedoch bei Systemen mit supraleitenden Magnetspulen im allgemeinen nicht zum gewünschten Erfolg, da der abschirmende Einfluß der supraleitenden Wicklungen noch nicht berücksichtigt ist. Dies wäre auch mit einem extrem großen Rechenaufwand verbunden.

Daher sieht die Erfindung vor, zusätzlich mindestens eine dritte Spule anzubringen, wie dies weiter unten noch im einzelnen erläutert werden wird.

Im Ergebnis kann sich dadurch eine Konfiguration ähnlich Fig. 2, jedoch mit einer zusätzlichen dritten Spule einstellen, die Konfiguration kann aber auch zum Schnittpunkt der Achsen 31, 32 unsymmetrisch sein, wie dies als Beispiel Fig. 3 zeigt. Dort sind statt der streng symmetrischen Anordnung gemäß Fig. 2 ein axial versetztes Spulenpaar 40a/40b, eine axial versetzte Solenoidspule 41 sowie eine axial versetzte Ringspule 42 vorgesehen. Von diesen drei Spulen 40a/40b, 41 und 42 ist jeweils eine eine Induktionsspule und eine eine Kompensationsspule, während die dritte Spule eine Induktionsspule oder eine Kompensationsspule sein kann.

Der Elektro-Luftspulenmagnet gemäß Fig. 3 kann erfindungsgemäß unterschiedlich gestaltet werden.

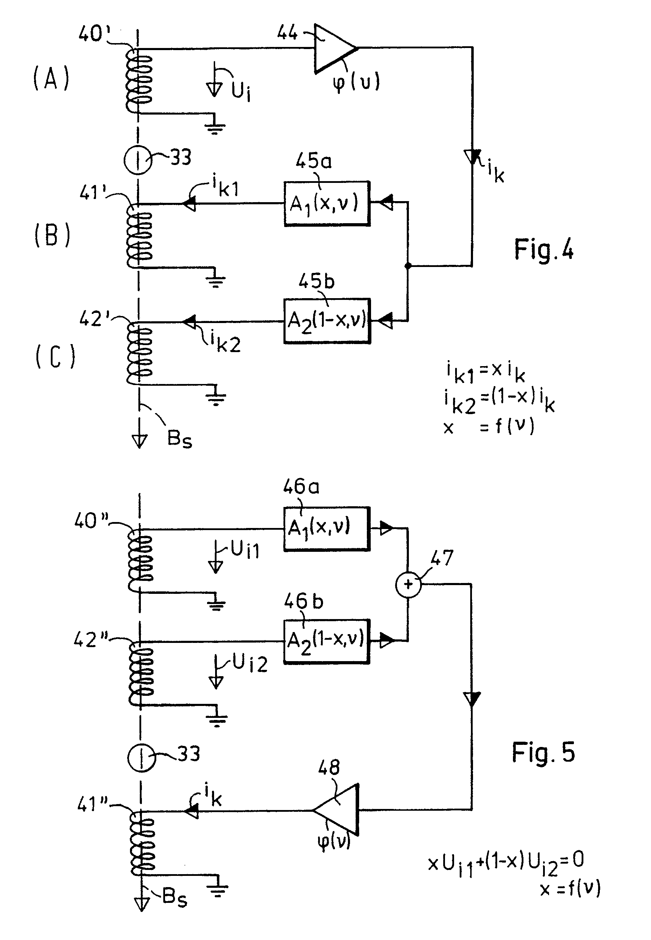

Fig. 4 zeigt eine erste Variante, bei der die Spulen 40, 41 und 42 jeweils mit einem Apostroph versehen sind. Die erste Spule 40 dient als Induktionsspule 40' und liefert eine Induktionsspannung $U_i$, die einem Verstärker 44 zugeführt wird. Der Verstärker 44 erzeugt einen Kompensationsstrom $i_k$, der auf zwei Attenuatoren (Abschwächer) 45a und 45b geführt wird. Dadurch wird der Strom $i_k$ nach den Beziehungen:

$$i_{k1} = x i_k \text{ bzw.}$$
$$i_{k2} = (1\text{-}x)\, i_k$$

aufgeteilt. Der Teilstrom $i_{k1}$ durchströmt die als erste Kompensationsspule geschaltete zweite Spule 41', während der zweite Teilstrom $i_{k2}$ die als zweite Kompensationsspule geschaltete Spule 42' durchfließt.

Die Elemente 45a und 45b können auch als Verstärker realisiert sein. Sie können einen einstellbaren Frequenzgang $f(\nu)$ aufweisen, so daß die Stromaufteilung, d. h. der Parameter x, eine Funktion der Frequenz ist und damit frequenzabhängig optimiert werden kann. Einer der beiden Attenuatoren 45a, 45b, kann prinzipiell entfallen. Im einfachsten Fall können die Attenuatoren 45a, 45b durch Potentiometer realisiert sein. Wegen der einstellbaren Frequenzcharakteristik sind Operationsverstärker allerdings besonders vorteilhaft. Da es im wesentlichen auf das Verhältnis von $i_{k1}$ zu $i_{k2}$ ankommt, sind auch Abwandlungen denkbar, bei denen die Summe aus $i_{k1}$ und $i_{k2}$ ungleich $i_k$ ist.

Sämtliche Spulen 40', 41' und 42' werden, ebenso wie der Probenraum 33 von der Stör-Induktion $B_s$ durchsetzt.

Um die Spulen 40', 41' und 42' zu positionieren, dimensionieren und zu erregen, geht man von der folgenden Überlegung aus, bei der die Spulen 40', 41' und 42' jeweils mit dem Index A, B und C charakterisiert sind.

Betrachtet man zunächst die induzierte Spannung $U_i$, so setzt sich diese zusammen aus Anteilen, die von einem Störfluß $\phi_s$ sowie den Teilströmen $i_{k1}$ und $i_{k2}$ unter Berücksichtigung der jeweiligen Gegeninduktivitäten $L_{BA}$ bzw. $L_{CA}$ erzeugt werden. Es ergibt sich:

$$U_i = d\phi_s dt + L_{BA} di_{k1}/dt + L_{CA} di_{k2}/dt \qquad (1)$$

bzw.

$$\phi_s + L_{BA} i_{k1} + L_{CA} i_{k2} = 0 \qquad (2)$$

Einsetzen der oben angegebenen Beziehung (2) für die Teilströme und der Beziehung zwischen magnetischem Fluß und Induktion liefert:

$$w_A A_A B_s + (x L_{BA} + (1-x)L_{CA})i_k = 0 \qquad (3)$$

wobei $w_A$ die Windungszahl und $A_A$ die Fläche der Spule 40' sind. Auflösen von (3) nach $i_k$ liefert:

$$i_k = \frac{-w_A A_A B_s}{x L_{BA} + (1-x)L_{CA}} \, ,\qquad (4)$$

Neben der Bedingung, daß die induzierte Spannung $U_i$ in der Induktionsspule 40' zu Null werden soll, soll auch die gesamte magnetische Induktion am Probenort zu Null werden. Diese gesamte magnetische Induktion $B_{tot}$ setzt sich zusammen aus den folgenden Beiträgen:

$$B_{tot} = B_s + B_A + B_B = 0 \qquad (5)$$

Division von (5) durch $B_s$ liefert:

$$B_{tot}/B_s = 1 + B_A/B_s + B_B/B_s = 0 \qquad (6)$$

Je nach gewählter Spulenkonfiguration und Spulenabmessungen kann man nun die in einer Spule vorhandene Induktion durch eine Beziehung K ausdrücken, in der der Durchmesser d, die Länge l, die Windungszahl w und der Stromanteil x eingehen. Für die in den Spulen 41' und 42' erzeugten Induktionen gilt damit:

$$B_A = K_A(d, \ l, \ w, \ x)x i_k \qquad (7)$$

$$B_B = K_B(d, \ l, \ w, \ x) (1-x)i_k \qquad (8)$$

Einsetzen von (4), (7) und (8) in (6) liefert schließlich:

$$B_{tot}/B_s = 1 - K_A'(d,l,w,x) - K_B'(d,l,w,x) = 0 \qquad (9)$$

(9) stellt eine Gleichung dar, in der alle Zwischengrößen, einschließlich der Gegeninduktivitäten durch Angaben über die Dimensionen, die Windungszahlen und die Stromanteile ersetzt sind. Bei einer asymmetrischen Konfiguration ähnlich Fig. 3 treten noch Terme mit den Positionen der asymmetrisch angeordneten Spulen hinzu.

Man geht nun so vor, daß zunächst für den Spezialfall $x = 0$ oder $x = 1$, d.h. für den Fall, daß nur eine der Kompensationsspulen 41' oder 42' wirksam und mit dem gesamten Kompensationsstrom $i_k$ beaufschlagt ist, für eine vorgegebene Grundkonfiguration die dann noch freien Parameter, beispielsweise die Breiten, Längen oder Windungszahlen der Spulen so optimiert werden, daß (9) erfüllt ist.

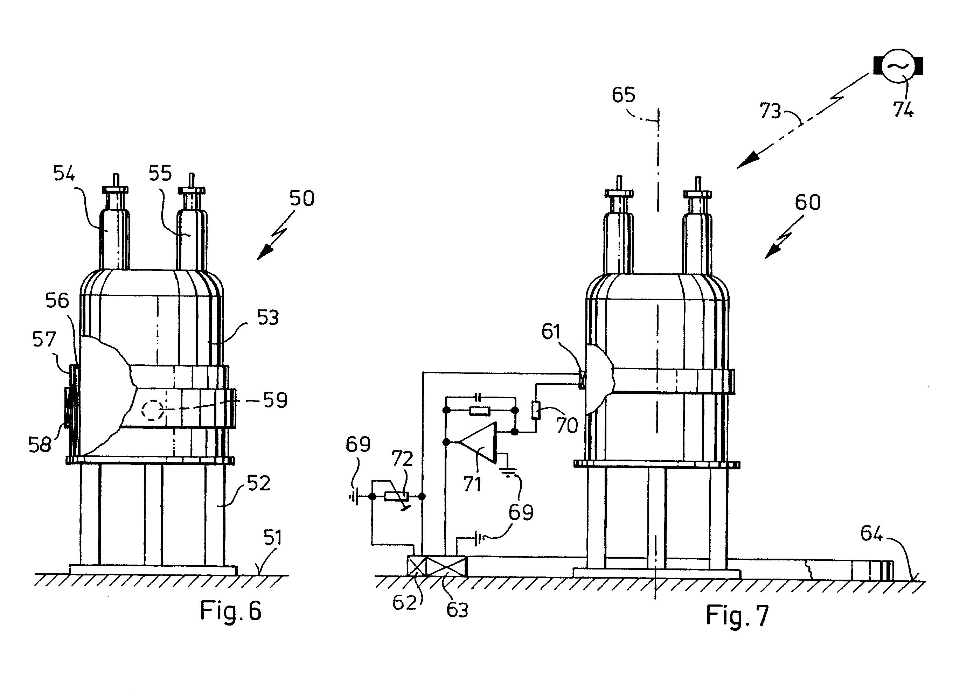

Geht man beispielsweise von einer symmetrischen Konfiguration, wie sie weiter unten zu Fig. 6 noch kurz erläutert werden wird, aus, bei der die Spule 42' außer Betracht bleibt und nur die Spulen 40' und 41' berücksichtigt werden, geht man ferner davon aus, daß diese beiden Spulen konzentrisch angeordnet sind und den Probenraum 33 in ihrem Zentrum umschließen, so kann man zeigen, daß bei gleicher axialer Länge der beiden Spulen 40' und 41' die Gleichung (9) dann erfüllt wird, wenn das Durchmesser/Längenverhältnis beider Spulen 40' und 41' gerade = $\sqrt{3}/2$, d.h. ca. 0,87 ist. Dies bedeutet, daß bei einer solchen Konfiguration, bei der die Spule 42' abgeschaltet bleibt, im Idealfalle die Störinduktion

$B_s$ im Probenraum 33 vollständig kompensiert wird und gleichzeitig die induzierte Spannung $U_i$ zu Null wird.

Allerdings gilt dies nur für ideale Verhältnisse, so daß sich der theoretisch berechnete Erfolg z.B. dann nicht einstellt, wenn die Spulen 40', 41' - wie dies aus Raumgründen unvermeidbar ist - mit der supraleitenden Magnetspule des Kryostaten koppeln. In diesem Falle wirkt die persistent geschaltete Supraleitungsspule als Abschirmung, so daß die weiter oben angestellte theoretische Betrachtung nicht mehr gilt.

Um diesen systematischen Fehler auszugleichen, ist daher erfindungsgemäß vorgesehen, die zweite Kompensationsspule 42' ebenfalls einzuschalten und den Kompensationsstrom $i_k$ auf die beiden Spulen 41' und 42' aufzuteilen. Auf diese Weise gelingt selbst bei Anwesenheit störender Einbauten, wie dies geschildert wurde, die vollständige Kompensation der Störinduktion $B_s$.

Eine zu Fig. 4 gleichwertige Verschaltung ist in Fig. 5 dargestellt, bei der die Spulen 40, 41, 42 gemäß Fig. 3 so eingesetzt werden, wie dies in Fig. 5 mit einem Doppelapostroph angedeutet ist. Die Spulen 40″ und 42″ sind in diesem Fall als zwei induktionsspulen eingesetzt, während die Spule 41″ als einzige Kompensationsspule dient. Die an den Induktionsspulen 40″ und 42″ abfallenden Signalspannungen werden über zwei Attenuatoren 46a, 46b einem Spannungsaddierer 47 zugeführt, wobei der Verstellfaktor wiederum x ist. Die Summe der beiden abgegriffenen Spannungen wird einem Verstärker 48 zugeführt, der daraus den Kompensationsstrom $i_k$ erzeugt.

Die Attenuatoren können einen einstellbaren Frequenzgang $f(\nu)$ aufweisen. Ein Attenuator kann prinzipiell entfallen. Im einfachten Fall kann die Spannungsabschwächung und -addition durch eine Potentiometerschaltung erreicht werden.

Mit der Anordnung gemäß Fig. 5 läßt sich eine Überlegung, wie sie bereits weiter oben ausführlich dargestellt wurde, ableiten und die Ergebnisse sind entsprechend übertragbar.

Fig. 6 zeigt, wie dies bereits weiter oben kurz angedeutet wurde, ein erstes Ausführungsbeispiel eines supraleitenden Magnetsystems 50, der auf einem Boden 51 eines Experimentierraumes steht. Auf einem Gestell 52 oberhalb des Bodens 51 befindet sich ein Cryostat 53 mit Anschlüssen 54, 55 für flüssiges Helium bzw. flüssigen Stickstoff.

Auf dem Außenmantel des Cryostaten 53 sind eine Induktionsspule 56 sowie dicht darauf eine erste Kompensationsspule 57 gleicher axialer Länge gewickelt und auf die erste Kompenstationsspule 57 ist noch eine zweite Kompensationsspule 58 geringerer axialer Länge, jedoch in symmetrischer Anordnung gewikkelt. Die Spulenanordnung 56/57/58 umschließt in ihrem Symmetriezentrum einen Probenraum 59.

Wie bereits weiter oben zur theoretischen Herleitung der erforderlichen Beziehungen zu Fig. 4 erläutert wurde, würden die Induktionsspule 56 und die erste Kompensationsspule 57 theoretisch bereits ausreichen, um die Feldstörung im Probenraum 59 vollkommen auszugleichen, sofern die Spulen 56/57 in der genannten Weise dimensioniert und angeordnet sind. Die zweite Kompensationsspule 58 dient demgegenüber dazu, die realen Effekte auszugleichen, die durch Anwesenheit des Cryostaten 53 und der darin angeordneten supraleitenden Magnetspule hervorgerufen sind.

Fig. 7 zeigt ein weiteres Ausführungsbeispiel eines supraleitenden Magnetsystems 60 mit einer ersten Induktionsspule 61, die in etwa halber Höhe um den Cryostaten gewickelt ist. Eine zweite Induktionsspule 62 befindet sich ebenso wie eine Kompensationsspule 63 auf einem Boden 64 unterhalb des Cryostaten. Alle Spulen 61, 62, 63 sind konzentrisch zur Hochachse 65 des supraleitenden Magnetsystems 60 angeordnet.

Beim Ausführungsbeispiel gemäß Fig. 7 wird eine Beschaltung ähnlich Fig. 5 eingesetzt, bei der die Induktionsspulen 61, 62 in der Reihe zwischen einer Masse 69 und - über einen Vorwiderstand 70 - an einem Integrier-Verstärker 71 liegen. Die gegenläufige Spannungsaddition wird mittels eines Potentiometers 72 eingestellt.

Mit 73 ist eine Fernstörung angedeutet, die beispielsweise von einem Aufzug oder einer Straßenbahn erzeugt werden kann. Die Fernstörung 73 durchdringt den gesamten supraleitenden Magneten 60, ebenso wie die Induktionsspulen 61 und 62, wobei die Induktionsspule 62 die gesamte Fernstörung aufnimmt, während die Induktionsspule 61 durch die Kopplungen den supraleitenden Magneten 60 nur einen Teil davon aufnimmt. Durch die Erzeugung des Kompensationsfeldes in der sehr großen am Boden 64 angeordneten Kompensationsspule 63 wird ein Kompensationsfeld erzeugt, das von seiner Art her einer Fernstörung sehr ähnlich ist.

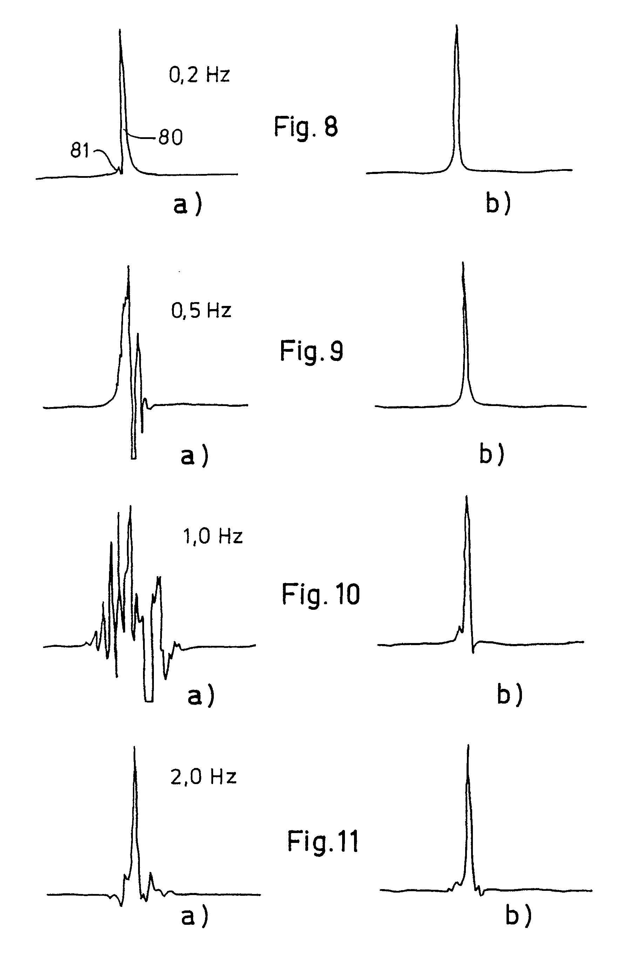

Die Figuren 8 bis 11 zeigen Messungen, die mit einer Anordnung ähnlich Fig. 7 durchgeführt wurden und jeweils in einem Teilbild a) eine gestörte Kernresonanzlinie und im Teilbild b) eine mit der erfindungsgemäßen Vorrichtung kompensierte Messung zeigen.

Fig. 8 zeigt den Fall, daß die Fernstörung 73, die für die Messungen der Fig. 8 bis 11 allerdings in definierter Weise erzeugt wurde, eine Frequenz von 0,2 Hz bei einer Intensität von ca. 40 mG aufwies. Man erkennt, daß sich neben der Kernresonanzlinie 80 ein kleines Seitenband 81 ausgebildet hat, das bei der erfindungsgemäß kompensierten Messung gemäß Fig. 8b vollkommen verschwunden ist.

Ähnliches, jedoch noch in weit deutlicherem Maße zeigt sich bei der Darstellung gemäß Fig. 9a und 9b, wo die Fernstörung 73 bei gleicher Intensität eine Frequenz von 0,5 Hz aufwies. Auch bei diesem Störungsfall gelang es, diese Störung erfindungsgemäß vollkommen zu eliminieren.

Die Darstellung nach Fig. 10a zeigt, wieder bei gleicher Störungsamplitude, den Effekt einer Störfrequenz von 1,0 Hz. Es wurde bereits weiter oben erwähnt, daß supraleitende Magnetspulen der hier interessierenden Art im Frequenzbereich um 1,0 Hz eine ausgeprägte Eigenresonanz aufweisen können, so daß sich Fernstörungen 73 mit dieser Frequenz besonders unangenehm bemerkbar machen, wie Fig. 10a deutlich zeigt, weil dort Eigenresonanzen in der supraleitenden Magnetspule angeregt wurden. Wie Fig. 10b zeigt, gelingt es jedoch auch in diesem Falle, die Störungen weitgehend zu kompensieren.

Fig. 11 zeigt eine Störung der Frequenz 2,0 Hz und man erkennt, daß auch diese Störung weitgehend bei Einsatz einer erfindungsgemäßen Vorrichtung kompensiert werden kann.

## Ansprüche

1. Vorrichtung zum Kompensieren von Zeitvarianten Feld-Störungen in dem Magnetfeld, das in dem Probenraum eines supraleitenden Elektromagneten mit hoher Feldhomogenität herrscht, mit mindestens einer Induktionsspule zum Erfassen des den Probenraum durchsetzenden Magnetfeldes, einem auf die in die Induktionsspule induzierte Spannung ansprechenden Steuergerät und mindestens einer den Probenraum umschließenden Kompensationsspule, der ein mittels des Ausgangssignales des Steuergerätes eingestellter Kompensationsstrom zugeführt wird, dadurch gekennzeichnet, daß mindestens eine Induktionsspule (40'; 56) und mindestens zwei Kompensationsspulen (41', 42'; 57, 58) vorgesehen sind, die alle im wesentlichen koaxial zur Feldspule (30), mindestens zwei von ihnen außerhalb derselben angeordnet sind, wobei die Kompensationsspulen (41' 42'; 57, 58) in unterschiedlicher Weise die Feldverteilung im Probenraum beeinflussen, daß das Steuergerät eine Regelstufe (44, 45) bildet und daß in dieser Regelstufe ein Stromteiler (45a, 45b) zum Aufteilen des Kompensationsstromes ($i_{k1}$, $i_{k2}$) in zwei den beiden Kompensationsspulen (41', 42'; 57, 58) zugeführte, gewichtete Anteile vorgesehen ist.

2. Vorrichtung zum Kompensieren von zeitvarianten Feldstörungen in dem Magnetfeld, das in dem Probenraum eines supraleitenden Elektromagneten mit hoher Feldhomogenität herrscht, mit mindestens einer Induktionsspule zum Erfassen des den Probenraum durchsetzenden Magnetfeldes, einem auf die in die Induktionsspule induzierte Spannung ansprechenden Steuergerät und mindestens einer den Probenraum umschließenden Kompensationsspule, der ein mittels des Ausgangssignales des Steuergerätes eingestellter Kompensationsstrom zugeführt wird, dadurch gekennzeichnet, daß mindestens eine Kompensationsspule (41"; 63) und mindestens zwei Induktionsspulen (40", 42" ;61, 62) vorgesehen sind, die alle im wesentlichen koxial zur Feldspule (30), mindestens zwei von ihnen außerhalb derselben angeordnet sind, wobei die Induktionsspulen (40", 42" ;61, 62) in unterschiedlicher Weise auf die Feldverteilung im Probenraum ansprechen, daß das Steuergerät eine Regelstufe (46, 47) bildet und in dieser Regelstufe ein Spannungsaddierer (46a, 46b, 47; 72) vorgesehen ist, dem die in den mindestens zwei Induktionsspulen (40" , 42" ;61, 62) induzierten Spannungen ($U_{l1}$, $U_{l2}$ )mit vorgegebenem Gewicht zugeführt werden und von dessen Ausgangssignal die Regelstufe den Kompensationsstrom ableitet.

3. Vorrichtung nach Anspurch 1 oder 2, dadurch gekennzeichnet, daß die Kompensationsspule (63) in axialen Abstand von der Feldspule des Elektromagneten (60) angeordnet ist und einen Durchmsser aufweist, der wesentlich größer ist als und vorzugsweise mindestens doppelt so groß ist wie der Durchmesser der Feltspule.

4. Vorrichtung nach Anspruch 3, dadurch gekennzeichnet, daß der Elektromagnet (60) einem Gestell (52) oberhalb eines Bodens (64) mit senkrechter Achse angeordnet ist und daß die Kompensationsspule (63) auf dem Boden (64) unterhalb des Gestells (52) angeordnet ist.

5. Vorrichtung nach einem der vorhergehenden Ansprüche, dadurch gekennzeichnet, daß der Elektromagnet der Magnet (50; 60) eines Kernresonanzspektrometers ist, das einen Regelkreis aufweist, in dem die spektrale Lage eine vorbestimmten Linie einer Referenzprobe überwacht und in Abhängigkeit von einer Verschiebung der Linie ein Kompensationsfeld mittels eine Spule erzeugt wird und daß die Spule gleichzeitig als Kompensationsspule (41', 42'; 41''; 57, 58; 63) dient.

6. Vorrichtung nach einem der Ansprüche 1 bis 4, dadurch gekennzeichnet, daß der Elektromagnet ein Magnet eines Massenspektrometers ist.

7. Vorrichtung nach einem der vorhergehenden Ansprüch, dadurch gekennzeichnet, daß die Regelstufe (36; 44, 45; 46, 47; 69 70, 71) im Frequenzbereich von etwa 0,05 bis 5 Hz arbeitet.

8. Vorrichtung nach einem der vorhergehenden Ansprüche, dadurch gekennzeichnet, daß die Regelstufe (36; 44, 45, 46, 47, 48; 69, 70, 71) einen nach Amplitude und Phase einstellbaren Frequenzgang aufweist.

9. Vorrichtung nach einem der Ansprüche 1 und 3 bis 8, dadurch gekennzeichnet, daß Amplituden- und Phasengang mindestens eines Elementes (45a, 45b) der Regelstufe des Stromteilers (45a, 45b) als Funktion der Frequenz einstellbar ist.

10. Vorrichtung nach einem der Ansprüche 2 bis 8, dadurch gekennzeichnet, daß Amplituden- und Phasengang mindestens eines Elementes (46a, 46b) der Regelstufe des Spannungsaddierers (46a, 46b, 47; 72) als Funktion der Frequenz einstellbar ist.

## Claims

1. Device for the compensation of time-variant field distortions in the magnetic field which prevails in the probe chamber of a super-conducting electromagnet with high field homogeneity, with at least one induction coil for detecting the magnetic field penetrating the probe chamber, a control device which reacts to the voltage induced into the induction coil, and at least one compensation coil which surrounds the probe chamber and to which there is guided a compensation current adjusted by the output signal of the control device,
characterized in that
at least one induction coil (40', 56) and at least two compensation coils (41', 42'; 57, 58) are provided, all of which are arranged essentially coaxially with respect to the field coil (30), at least two of which are arranged outside the field coil (30), the compensation coils (41', 42'; 57, 58) influencing the field arrangement in the probe chamber in different ways; in that the control device forms a regulating stage (44, 45); and in that in this regulating stage there is provided a current dividing device (45a, 45b) for dividing the compensation current ($i_{k1}$, $i_{k2}$) into two weighted portions which are guided to the two compensation coils (41', 42'; 57, 58).

2. Device for the compensation of time-variant field distortions in the magnetic field, which prevails in the probe chamber of a super-conducting electromagnet with high field homogeneity, with at least one induction coil for detecting the magnetic field penetrating the probe chamber, a control device which reacts to the voltage induced into the induction coil, and at least one compensation coil which surrounds the probe chamber and to which there is guided a compensation current controlled by the output signal of the control device,
characterized in that
there are provided at least one compensation coil (41''; 63) and at least two induction coils (40'', 42''; 61, 62) which are all arranged essentially coaxially with respect to the field coil (30), of which at least two are arranged outside the latter, the induction coils (40'', 42''; 61, 62) reacting in different ways to the field arrangement in the probe chamber; in that the control device forms a regulating stage (46, 47) and in this regulating stage there is provided a voltage adding device (46a, 46b, 47; 72) to which the voltages ($U_{i1}$, $U_{i2}$), which have a given weight and are induced into at least two induction coils (40'', 42''; 61, 62), are guided, and from the output signal of which voltage adding device the regulating stage derives the compensation current.

3. Device according to claim 1 or 2, characterized in that the compensation coil (63) is arranged at an

EP 0 257 371 B1

axial distance from the field coil of the electromagnet (60) and has a diameter which is essentially greater than and preferably at least double the size of the diameter of the field coil.

4. Device according to claim 3, characterized in that the electromagnet (60) is associated with a support (52) above a base (64) having a vertical axis; and in that the compensation coil (63) is arranged on the base (64) below the support (52).

5. Device according to any one of the preceding claims, characterized in that the electromagnet is the magnet (50; 60) of a nuclear-resonance spectrometer which comprises a regulating circuit in which the spectral position monitors a predetermined line of a reference probe and a compensation field is generated by means of a coil in dependence on a shifting of the line and in that the coil serves at the same time as compensation coil (41', 42'; 41''; 57, 58; 63).

6. Device according to any one of claims 1 to 4, characterized in that the electromagnet is a magnet of a mass spectrometer.

7. Device according to any one of the preceding claims, characterized in that the regulating stage (36; 44, 45; 46, 47; 69, 70, 71) operates in the frequency range of approximately 0.05 to 5 Hz.

8. Device according to any one of the preceding claims, characterized in that the regulating stage (36; 44, 45, 46, 47,48; 69, 70, 71) comprises a frequency response which can be adjusted to amplitude and phase.

9. Device according to any one of claims 1 and 3 to 8, characterized in that the amplitude response and the phase response of at least one element (45a, 45b) of the regulating stage of the current dividing device (45a, 45b) is adjustable as function of the frequency.

10. Device according to any one of claims 2 to 8, characterized in that the amplitude response and phase response of at least one element (46a, 46b) of the regulating stage of the voltage adding device (46a, 46b, 47, 72) is adjustable as function of the frequency.


**Revendications**

1. Dispositif de compensation de perturbations de champs, qui sont variables dans le temps, dans le champ magnétique, qui règne dans l'espace à sonde d'un électroaimant supraconducteur présentant une homogénéité de champ élevée, comprenant au moins une bobine d'induction pour la détection du champ magnétique traversant l'espace à sonde, un appareil de commande répondant à la tension induite dans la bobine d'induction et au moins une bobine de compensation entourant l'espace à sonde à laquelle est amenée un courant de compensation, qui est réglé au moyen du signal de sortie de l'appareil de commande, caractérisé en ce qu'il est prévu au moins une bobine d'induction (40'; 56) et au moins deux bobines de compensation (41', 42'; 57, 58), qui sont toutes agencées de manière sensiblement coaxiale par rapport à la bobine de champ (30) et dont au moins deux extérieurement par rapport à celle-ci, les bobines de compensation (41', 42'; 57, 58) influençant différemment la distribution de champ dans l'espace à sonde, en ce que l'appareil de commande forme un étage de réglage (44, 45) et en ce qu'il est prévu dans cet étage de réglage un répartiteur de courant (45a, 45b) destiné à la répartition du courant de compensation ($i_{k1}$, $i_{k2}$) en deux parties pondérées et amenées aux deux bobines de compensation (41', 42'; 57, 58).

2. Dispositif de compensation de perturbations de champs, qui sont variables dans le temps, dans le champ magnétique, qui règne dans l'espace à sonde d'un électroaimant supraconducteur présentant une homogénéité de champ élevée, comprenant au moins une bobine d'induction pour la détection du champ magnétique traversant l'espace à sonde, un appareil de commande répondant à la tension induite dans la bobine d'induction et au moins une bobine de compensation entourant l'espace à sonde à laquelle est amenée un courant de compensation, qui est réglé au moyen du signal de sortie de l'appareil de commande, caractérisé en ce qu'il est prévu au moins une bobine de compensation (41''; 63) et au moins deux bobines d'induction (40'', 42''; 61, 62), qui sont toutes agencées de manière sensiblement coaxiale par rapport à la bobine de champ (30) et dont au moins deux extérieurement par

11

rapport à celle-ci, les bobines d'induction (40", 42"; 61, 62) répondant différemment à la distribution de champ dans l'espace à sonde, en ce que l'appareil de commande forme un étage de réglage (46, 47) et en ce qu'il est prévu dans cet étage de réglage un additionneur de tension (46a, 46b, 47; 72), auquel sont amenées les tensions ($U_{i1}$, $U_{i2}$) de pondération prédéterminée, qui sont induites dans lesdites au moins deux bobines d'induction (40", 42"; 61, 62) et par le signal de sortie duquel l'étage de réglage déduit le courant de compensation.

3. Dispositif suivant la revendication 1 ou 2, caractérisé en ce que la bobine de compensation (63) est agencée à une certaine distance axiale de la bobine de champ de l'électroaimant (60) et en ce qu'elle présente un diamètre, qui est sensiblement supérieur à et de préférence au moins le double du diamètre de la bobine de champ.

4. Dispositif suivant la revendication 3, caractérisé en ce que l'électroaimant (60) est agencé sur un châssis (52) au-dessus d'une base (64) avec un axe perpendiculaire et en ce que la bobine de compensation (63) est agencée sur la base (64) en dessous du châssis (52).

5. Dispositif suivant l'une des revendications précédentes, caractérisé en ce que l'électroaimant constitue l'aimant (50; 60) d'un spectromètre à résonance nucléaire, qui présente un circuit de réglage et qui est agencé pour surveiller la ligne prédéterminée d'une sonde de référence, un champ de compensation étant engendré au moyen d'une bobine en fonction d'un décalage de la ligne, et en ce que la bobine sert simultanément de bobine de compensation (41', 42'; 41"; 57, 58; 63).

6. Dispositif suivant l'une des revendications 1 à 4, caractérisé en ce que l'électroaimant constitue un aimant d'un spectromètre de masse.

7. Dispositif suivant l'une des revendications précédentes, caractérisé en ce que l'étage de réglage (36; 44, 45; 46, 47; 69, 70, 71) travaille dans une gamme de fréquences de l'ordre de 0,05 à 5 Hz.

8. Dispositif suivant l'une des revendications précédentes, caractérisé en ce que l'étage de réglage (36; 44, 45, 46, 47, 48; 69, 70, 71) présente une courbe de réponse réglable suivant l'amplitude et la phase.

9. Dispositif suivant l'une des revendications 1 et 3 à 8, caractérisé en ce que l'allure d'amplitude et de phase d'au moins un élément (45a, 45b) de l'étage de réglage du répartiteur de courant (45a, 45b) est réglable en fonction de la fréquence.

10. Dispositif suivant l'une des revendications 2 à 8, caractérise en ce que l'allure d'amplitude et de phase d'un élément (46a, 46b) de l'étage de réglage de l'additionneur de tension (46a, 46b, 47; 72) est réglable en fonction de la fréquence.

Fig. 1

Fig. 2

Fig. 3

Fig. 4

$i_{k1} = x\,i_k$
$i_{k2} = (1-x)\,i_k$
$x = f(\nu)$

Fig. 5

$x\,U_{i1} + (1-x)\,U_{i2} = 0$
$x = f(\nu)$

Fig.7

Fig.6

0,2 Hz

Fig. 8

81 ⌐ 80

a)

b)

0,5 Hz

Fig. 9

a)

b)

1,0 Hz

Fig. 10

a)

b)

2,0 Hz

Fig. 11

a)

b)